**Europäisches Patentamt**

**European Patent Office**

**Office européen des brevets**

(11) Veröffentlichungsnummer: **0 241 764**
**B1**

(12) **EUROPÄISCHE PATENTSCHRIFT**

(45) Veröffentlichungstag der Patentschrift: **01.08.90**

(21) Anmeldenummer: **87104229.7**

(22) Anmeldetag: **23.03.87**

(51) Int. Cl.⁵: **G 01 R 31/34, H 02 H 7/06**

(54) Verfahren und Vorrichtungen zur Erkennung und Lokalisierung von Schäden in elektrischen Anlagen.

(30) Priorität: **14.04.86 DE 3612475**

(43) Veröffentlichungstag der Anmeldung:
**21.10.87 Patentblatt 87/43**

(45) Bekanntmachung des Hinweises auf die
Patenterteilung:
**01.08.90 Patentblatt 90/31**

(84) Benannte Vertragsstaaten:
**CH DE FR GB LI**

(56) Entgegenhaltungen:

PATENT ABSTRACTS OF JAPAN, Band 7, Nr.
256 (P-236)1401r, 15. November 1983; & JP-A-58
140 653

SIEMENS POWER ENGINEERING &
AUTOMATION, Band 7, Nr. 1, Januar/Februar
1985, Seiten 26-29, Berlin, DE; P. GRÜNEWALD
et al.: "RF monitoring of the windings of
electrical machines"

I.S.A. TRANSACTIONS, Band 11, Nr. 2, 1973,
Seiten 168-177, Pittsburgh, US; G.S. HOPE et
al.: "Power transmission line abnormalities:
analysis and detection"

(73) Patentinhaber: **Siemens Aktiengesellschaft**
**Wittelsbacherplatz 2**
**D-8000 München 2 (DE)**

(72) Erfinder: **Grünewald, Peter, Dipl.-Ing.(FH)**
**Berghausweg 19**
**D-4300 Essen-Haarzopf (DE)**
Erfinder: **Weidner, Jürgen, Dipl.-Ing.**
**Am Ehrenmal 35**
**D-4300 Essen-Überruhr (DE)**
Erfinder: **Fork, Kurt, Dr.**
**Rosenbach 33**
**D-8524 Neunkirchen (DE)**
Erfinder: **Koziel, Reinhold**
**Zehntweg 215**
**D-4330 Mülheim/Ruhr (DE)**

(56) ·References cited:
SIEMENS POWER ENGINEERING &
AUTOMATION, Band 7, Nr. 4, Juli/August 1985,
Seiten 285-290, Berlin, DE; M. ERCHE: "Network
analyzer for studies of electromagnetic
transients in high-voltage networks"

EP 0 241 764 B1

(56) References cited:
PROCEEDINGS, INTERNATIONAL
CONFERENCE ON ELECTRICAL MACHINES, 18.-
21. September 1984, Lausanne, Teil 3, Seiten
964-967; J.C. MAUN: "Simulation of large
turbo-alternator operations an aid for machine
protections studies and tests"

**Beschreibung**

Die vorliegende Erfindung betrifft ein Verfahren zur Erkennung und Lokalisierung von Schäden in elektrischen Anlagen gemäß dem Oberbegriff des Anspruchs 1, sowie eine Vorrichtung gemäß dem Oberbegriff des Anspruchs 7 zur Durchführung des Verfahrens.

Aus einem Fachaufsatz von H. Nieschwietz und W. Stein in der "Elektrotechnischen Zeitschrift etz-a", Band 97 (1976), Heft 11, S. 657 bis 663, von dem die vorliegende Erdindung ausgeht, ist ein gatttungsgemäßes Verfahren bekannt. Es wird gemäß diesem Aufsatz als Mittel der Qualitätskontrolle an Hochspannungs-Transformatoren angewendet. In dem Aufsatz werden als alternative Verfarhen elektrische Teilentladungs-Messungen und Schall-Messungen beschrieben.

Ferner sind in der im Prioritätszeitraum der vorliegenden Patentschrift veröffentlichten DE—A—35 26 149.8 und den nachveröffentlichten EP—A—0 228 613 und EP—A—0 239 678, auf die hier ausdrücklich Bezug gennommen wird, Verfahren und Vorrichtungen zur Teilentladungs-Messung bzw. Hochfrequenz-Auskopplung und Ultraschallüberwachung bekannt. Zur Vermeidung von Wiederholungen wird daher für Einzelheiten dieser Messungen auf diese beiden Anmeldungen verwiesen.

Aufgabe der vorliegenden Erfindung ist es, aus den bisher bekannten Meßanordnungen bzw. -verfahren, eine Anordnung bzw. ein Verfahren zur globalen Betriebsüberwachung von electrischen Anlagen, insb. Generatoren bzw. Kraftwerksblöcken, zu schaffen, welches eine Früherkennung von Schäden und vor allem eine Diagnose und Lokalisierung der Schäden ermöglichen soll. Ferner soll durch Angabe besonders geeigneter und ohne große Umbaumaßnahmen einerichtbarer Meßstellen de Nachrüstung von Kraftwerksblöcken mit der erfindungsgemäßen Anordnung zur Durchführung des Verfahrens nach einem der Ansprüche 1—6 ermöglicht werden.

Zur Lösung dieser Aufgabe werden die Massnahmen gemäß dem 2. Teil des Anspruches 1 vorgeschlagen.

Anders als bei den nach dem Stand der Technik bekannten Verfahren soll die Auswertung dieser Meßsignale nicht nur durch Vergleich mit Kalibriersignalen erfolgen, sondern es soll die gesamte elektrische Anlage in einem Rechner als Hockfrequenz-Netzwerk nachgebildet werden, was auch die Simulierung von Schäden und die Verfolgung der durch diese Schäden entstehenden Signale durch das gesamte Netzwerk ermöglicht. Auf modernen Rechenanlagen ist es in an sich bekannter Weise möglich, Netzwerke nachzubilden und die Eingabe von Signalen an beliebigen Stellen in solchen Netzwerken zu simulieren und die Signalwege und dabei auftretenden Veränderungen der Signale zu verfolgen. Durch Vergliech von Meßsignalen mit simulierten Signalen läßt sich so eine sehr genaue Diagnose der Schadensart und des Schadensortes bewerkstelligen, wobei die Qualität der Diagnose naturgemäß mit der Anzahl der gewonnenen Meßwerte zunimmt.

Geeignete Meßstellen werden im Anspruch 2 angegeben und weitere vorteilhafte Ausgestaltungen der Erfindungen sind in den Ansprüchen 3 bis 6 enthalten, wie sie anhand der Zeichnung näher erläuteret werden.

Vorrichtungen zur Durchführung des Verfahrens werden in den Ansprüchen 7 und 8 beschrieben und ebenfalls anhand der Zeichnung näher erläutert.

Beispielhaft anhand eines Kraftwerksblockes ist eine Ausführungsmöglichkeit der Erfindung in der Zeichnung dargestellt. Es zeigen

Fig. 1 ein schematisches, an sich bekanntes Schaltbild eines Kraftwerkblockes mit Meßstellen zur Auskopplung von Hochfrequenz-Signalen und Schall-Signalen,

Fig. 2 einen schematischen Längsschnitt durch einen Turbogenerator mit Erregereinrichtung,

Fig. 3 und 4 schematische Flußpläne für die Verarbeitung und Auswertung der Meßsignale.

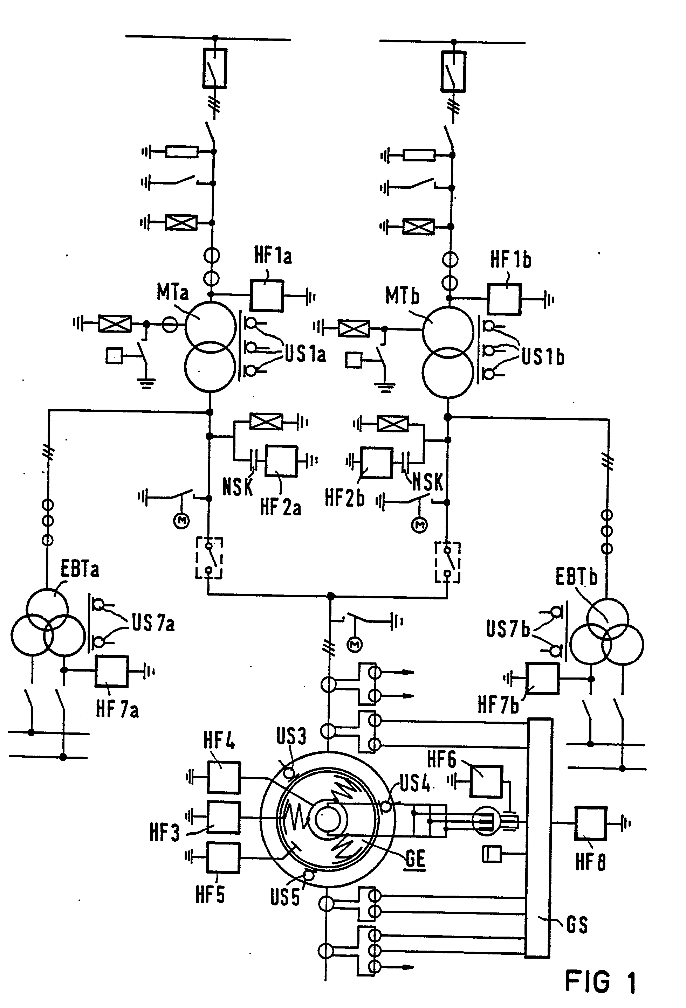

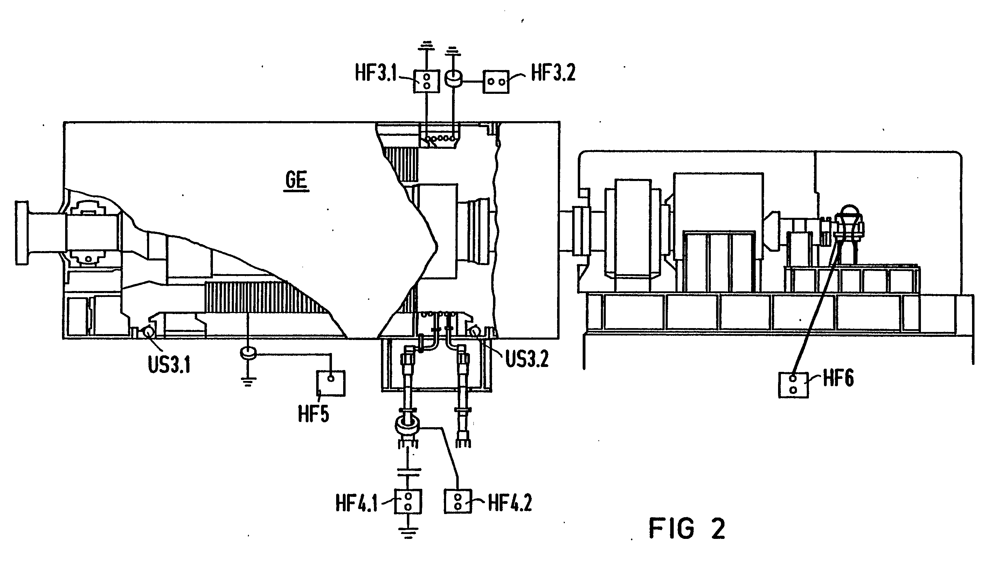

In Fig. 1, dem schematischen Schaltbild eines Kraftwerksblockes, sind die nach dem Stand der Technik an sich bekannten Einzelheiten, die für die Erfindung nicht von Bedeutung sind, nicht weiter bezeichnet. Wesentliche Teile sind der Generator GE, der Generator-Schutz GS, die beiden Maschinen-Transformatoren MT a, MT b, die beiden Eigenbedarfs-Transformatoren EBT a, EBT b und die Netzschutz-Kondensatoren NSK. Gemäß an sich bekannten oder in den nach veröffentlichten o.g. Patentanmeldungen enthaltenen Anordnungen, sind die angegebenen Einzelteile des Kraftwerksblockes mit Schallaufnehmern, insbesondere für Ultraschall-Signale, ausgerüstet. Die Maschinen-Transformatoren MT a bzw. MT b weisen je drei Schallaufnehmer US 1a bzw. US 1b auf, während die Eingenbedarfs-Transformatoren EBT a, bzw. EBT b mit beispielsweise je zwei Schallaufnehmern US 7a bzw. US 7b ausgestattet sind. Ferner weist der Generator GE in seinem vorderen und in seinem hinteren Wassersammelring (wie in Fig. 2 besser zu erkennen ist) beispielsweise je drei Schallaufnehmer US 2, US 4, US 5 auf. Alle diese Schallaufnehmer bilden insgesamt einen Zweig des vorgeschlagenen Betriebsüberwachungs-Systems, welcher Erkennung und teilweise Lokalisierung von Schäden aufgrund von Schall-Signalen ermöglicht.

Erfindungsgemäß wird zuzätzlich vorgeschlagen, einen Kraftwerksblock mit mindestens 3, vorzugsweise jedoch wesentlich mehr Meßstellen zur Auskopplung von Hochfrequenz (HF) auszurüsten. Solche Meßstellen können insbesondere in folgenden Einrichtungen bestehen:

a) HF 1a, HF 1b: Kapazitive Teiler der Hochspannungs-Durchführungen der Mashinen-Transformmatoren MT a, MT b;

b) HF 2a, HF 2b: Hochfrequenz-Winderstände in Verbindung mit Ankopplungsvierpolen als Unterteiler zu den vorhandenen Netzschutz-Kondensatoren NSK;

c) HF 3: Kapazitive HF 3.1 oder induktive HF 3.2

Kopplung innerhalb des Generators, strangweise an den Schaltleitungen durch Erdungsbeläge oder zusätzliche Koppelkapazitäten;

d) HF 4: Hochfrequenz-Stromwandler über Sternpunkt-Ableitung HF 4.1 oder kapazitiven Teiler HF 4.2 im Sternpunkt gegen Erde;

e) HF 5: Hochfrequenz-Stromwandler über eine separate Erdungsleitung des Ständerblechpaketes;

f) HF 6: Kapazitive Auskopplung über Generator-welle und Erregerlager evtl. mit zusätzlicher Antennen-Kopplung;

g) HF 7a, HF 7b: Kapazitive Auskopplung unter Benutzung des kabel-Erdbelages oder durch ohmsche Teiler mit Hockfrequenz-Charakteristik auf Eigenbedarf-Spannungsebene;

h) HF 8: Kapazitive oder galvanische (ohmsche) Anbindung im Generatorschutz GS.

Fig. 2 zeigt im Längs-Axialschnitt einen Turbogenerator GE mit Erregeranordnung, anhand dessen die räumliche Anordnung der in Fig. 1 im Schaltbild gezeigten Meßstellen verdeutlicht wird. An sich bekannte Teile des Turbogenerators, die dür die vorliegende Erfindung nicht von Bedeutung sind, werden dabei im einzelnen nicht erläutert. Erkennbar ist die Anordnung von Schallaufnehmern in den vorderen bzw. hinteren Wassersammelringen des Generators GE, wobei nur einer von jeweils 3 Aufnehmern in jedem Wassersammelring schematisch angedeutet ist. Im vorderen Wassersammelring ist dies der Aufnehmer US 3.2, im hinteren Wassersammelring der Aufnehmer US 3.1. Außerdem sind aus dieser Figur mehrere der in Fig. 1 angegebenen Meßstellen zur Hochfrequenz-Auskopplung mit ihrem schematisch angeduteten Aufbau angegeben. Wie dargestellt, ist eine Hochfrequenz-Auskopplung durch kapazitive HF 3.1 oder induktive HF 3.2 Kopplung innerhalb des Generators strangweise an den Schaltleitungen möglich, und zwar durch Erdungsbeläge oder zusätzliche Koppelkapazitäten. die Ankopplung an den Schaltleitungen ermöglicht eine besonders günstige Meßstelle. Ferner ist eine Auskoppelstelle durch Hochfrequenz-Stromwandler über Sternpunktableitung HF 4.1 oder einen kapazitiven Teiler im Sternpunkt gegen Erde HF 4.2 angedeutet. Eine weitere besonders günstige Meßstelle HF 5 ergibt sich durch einen Hockfrequenz-Stromwandler über eine separate Erdungsleitung des Ständerblechpaketes. Ferner ist eine weitere Meßstelle HF 6 gemäß der älteren nachveröffentlichten DE—A—35 43 927.0 angegeben, welche eine kapazitive Auskopplung über Generatorwelle und Erregerlager ermöglicht.

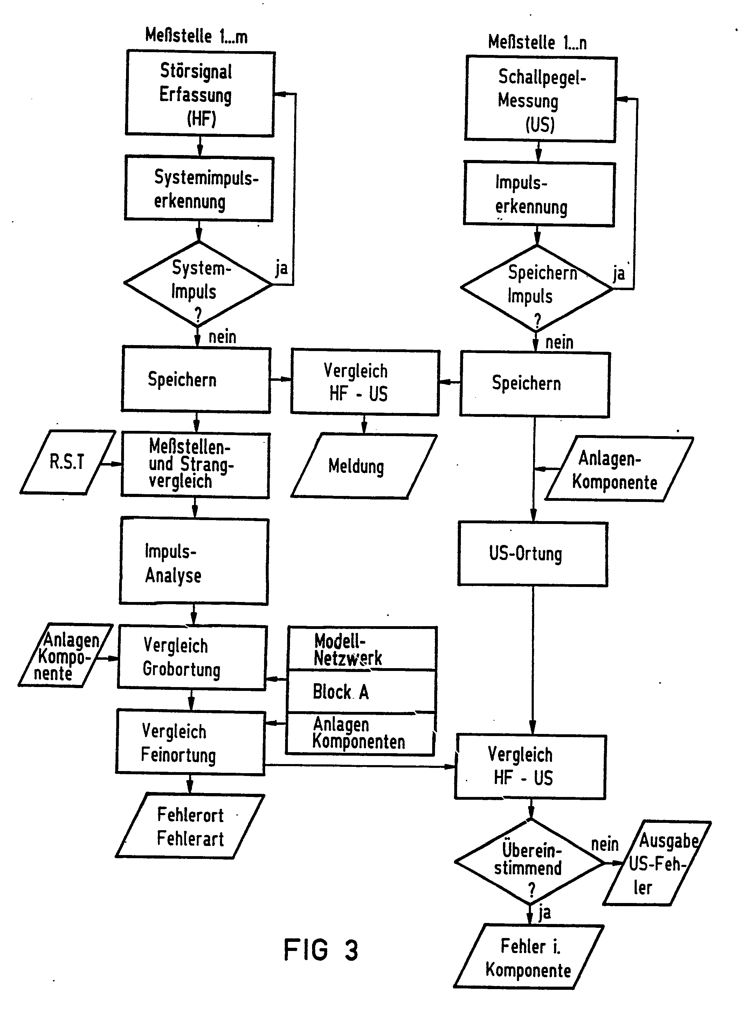

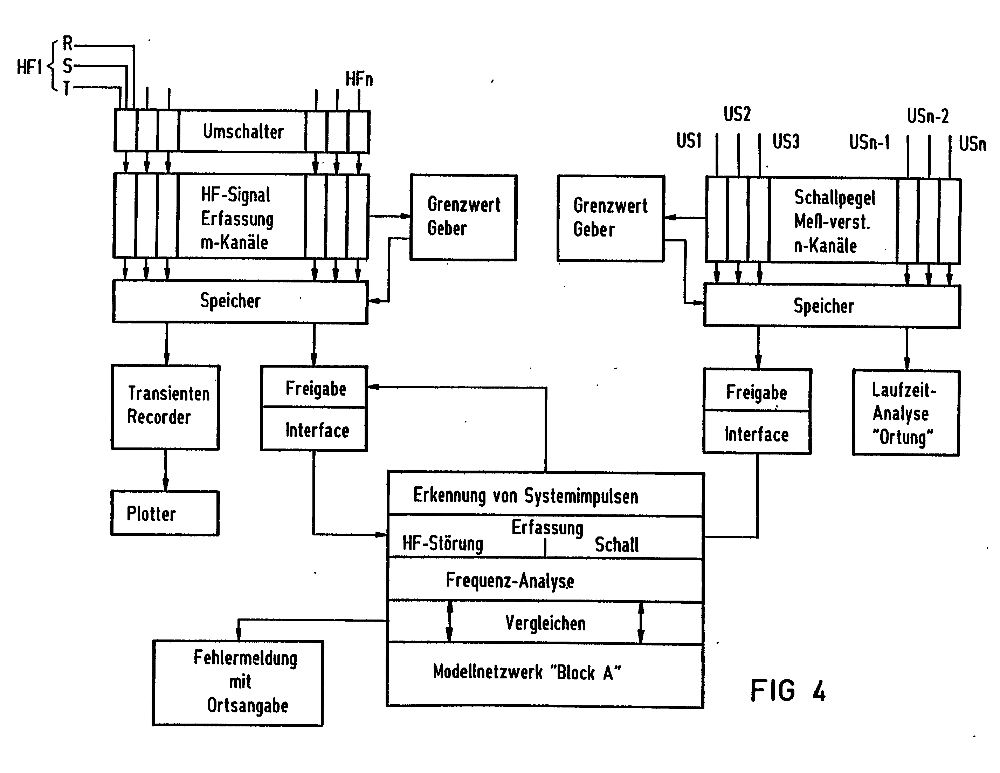

Die Auswertung der gewonnenen Betriebsmeßsignale wird anhand von Flußplänen in den Fig. 3 und 4 schematisch dargestellt. Dabei wird davon ausgegangen, daß m Meßstellen für Hochfrequenzsignale und n Meßstellen für Schall-Signale an der elektrischen Anlage vorhanden sind. Sowohl Hochfrequenzsignale (HF) wie auch Schall-Signale (US) werden zunächst daraufhin überprüft, ob die Signale vom störungsfreien Betrieb der Anlage stammen. Solche Signale sind für die Überwachung nicht von Bedeutung und werden nicht weiter verarbeitet. Abnorme Signale jedoch werden weitergegeben, gespeichert und zur weiteren Analyse verarbeitet kann zunächst ein Vergleich zwischen den HF- und den US-Signalen für eine erste Plausibiltatsuntersuchung herangezogen werden. Bei der Weiterverarbeitung der HF-Signale kann zunächst durch Vergleich der Meßsignale aus verschiedenen Phasen die schadhafte Phase festgestellt werden. Ferner ist durch Hinzuziehung der Schallsignale meist eine Feststellung der betroffenen Anlagenkomponente möglich. Nach dieser Groborung kann eine Feinanalyse mit Hilfe eines simulierten Fehlers in einem Modellnetzwerk des betroffenen Kraftwerksblockes bzw. der Komponente durchgeführt werden. Diese Feinanalyse liefert dann eine Diagnose mit Angaben über die Fehlerart und den Fehlerort. Auch in diesem Stadium ist wiederum ein Vergleich mit den sich aus den Schall-Signalen ergebenden Diagnosen möglich, Ggf. noch vorhandene Diskrepanzen können ebenfalls angezeigt, ausgedruckt oder gespeichert werden.

Fig. 4 zeigt weitere Einzelheiten der Auswertung. Zunächst wird angedeutet, daß es sich bei den HF- bzw. US-Signalen jeweils um eine größere Zahl von Meßstellen und Meßwerten handeln kann. Die Meßstellen für Hochfrequenz-Signale sind dabei teilweise noch für jeweils drei Phasen R, S, T, ausgelegt. Über Grenzwertgeber wird eine Vorauswahl der erfaßten Signale getroffen, wobei Signale, die vorgebbare Grenzwerte überschreiten, gespeichert und weiter analysiert werden. Wiederum erfolgt eine Analyse zur Erkennung von Systemimpulsen, d.h. von Impulsen, welche nicht auf eine ein Störung, sondern auf den üblichen Betrieb der Anlage hinweisen. Erkannte Störimpulse werden — wie schon erläutert — mit simulierten Signalen verglichen und das Ergebnis ausgedruckt oder angezeigt. Zusätzlich ist eine Untersuchung durch Transienten-Rekorder und digl. möglich mit einem Ausdruck der sich ergebenden Bilder. Bei den Schall-Signalen ist eine Ortung auch über reine Laufezeitanalyse in an sich bekannter Weise möglich.

Die vorliegende Erfindung eignet sich besonders zur Früherkennung von Störungen bei elektrischen Anlagen, die sich durch Teilentladungen oder Abreißfunken u. dgl. bemerkbar machen.

## Patentansprüche

1. Verfahren zur Erkennung und Lokalisierung von Schäden in elektrischen Anlagen, insbesondere Generatoren bzw. Kraftwerksblöcke, wobei an einer oder mehreren Stellen der elektrischen Anlage Teilentladungsmessungen bzw. Hochfrequenzmessungen (HF 1a, HF 1b, HF 2a, HF 2b, HF 3, HF 4, HF 5, HF 6, HF 7a, HF 7b, HF 8), ggf. jeweils allen Phasen, durchgeführt werden und wobei die Meßwerte untereinander oder mit Kalibriersignalen verglichen werden und daraus auf den Ort und die Art des Schadens geschlossen wird, gekennzeichnet durch folgende Merkmale:

a) Die Messungen werden während des Betriebes der Anlage kontinuierlich oder periodisch an mindestens drei Stellen durchgeführt;

b) die elektrische Anlage wird in einem Rechner als Hochfrequenz-Netzwerk nachgebildet, wobei auch Schäden mit ihren daraus an den Meßstellen entstehenden Signalen simulierbar sind;

c) bei Auftreten von Meßwerten, die aus Schäden hinweisen, werden diese mit den simulierten Signalwerten für verschiedene Schäden und Schadensorte verglichen, insbesondere bezüglich Frequenzspektrum, Laufzeit, Amplitude und/oder Phasenlage;

d) die Art und der Ort des Schadens werden aus den am besten mit den Meßwerten übereinstimmenden simulierten Signalwerten und den zugehörigen simulierten Schäden ermittelt.

2. Verfahren nach Anspruch 1, dadurch gekennzeichnet, daß während des Betriebes mindestens drei der im folgenden angegebenen Messungen durchgeführt werden.

a) Hochfrequenz-Auskopplung über an sich bekannte kapazitive Teiler der Hochspannungs-Durchführungen der Trafos (HF 1a, HF 1b);

b) Hochfrequenz-Auskopplung HF 2a, HF 2b über Hochfrequenz-Widerstände in Verbindung mit Ankopplungsvierpolen als Unterteiler zu den vorhandenen Netzschutzkondensatoren (NSK);

c) Hochfrequenz-Auskopplung durch kapazitive (HF 3.1) oder induktive (HF 3.2) Kopplung innerhalb des Generators (GE) strangweise an den Schaltleitungen;

d) Hochfrequenz-Auskopplung durch Hochfrequenz-Stromwandler über Sternpunkt-tableitung (HF 4.1) oder kapazitiven Teiler im Sternpunkt gegen Erde (HF 4.2);

e) Hochfrequenz-Auskopplung durch Hochfrequenz-Stromwandler über eine separate Erdungsleitung des Ständerblechpaketes (HF 5);

f) Hochfrequenz-Auskopplung, kapazitiv, über Generatorwelle und Erregerlager (HF 6), evtl. mit zusätzlicher Antennkopplung;

g) Hochfrequenz-Auskopplung über kapazitive Benutzung des Kabel-Erdbelages oder ohmsche Teiler mit Hochfrequenz-Charakteristik auf der Eigenbedarf-Spannnngsebene (HF 7a, HF 7b);

h) Hochfrequenz-Auskopplung über kapazitive oder galvanische bzw. ohmsche Anbindung (HF 8) im Generator-schutz (GS).

3. Verfahren nach Anspruch 1 oder 2, dadurch gekennzeichnet, daß zur Ortung der betroffenen Phase die Meßwerte der 3 Phasen untereinander verglichen werden.

4. Verfahren nach Anspruch 1, 2 oder 3, dadurch gekennzeichnet, daß die Meßstellen untereinander, ggf. getrennt nach Phasen verglichen werden.

5. Verfahren nach einem der vorhergehenden Ansprüche, dadurch gekennzeichnet, daß die Störsignale der verschiedenen Meßstellen über Transientenrekorder und/oder auf dem Oszillographenbildschirm nach Höhe, Form und/oder Phasenlage analysiert werden.

6. Verfahren nach einem der vorhergehenden Ansprüche, dadurch gekennzeichnet, daß zusätzlich Meßwerte von Schallmeßaufnehmern (US 1a, US 1b, US 3, US 4, US 5, US 7a, US 7b) mit überwacht und bei der Analyse des Schadens mit herangezogen werden.

7. Vorrichtung zur Durchführung des Verfahrens nach einem der Ansprüche 1 bis 6 an einem Kraftwerksbock, dadurch gekennzeich, net, daß der Kraftwerksblock an seinem Generator (GE) und/oder weiteren Bauteilen drei oder mehr Betriebsmeßstellen zur Hochfrequenz-Auskopplung (HF 1a, HF 1b, HF 2a, HF 2b, HF 3, HF 4, HF 5, HF 6, HF 7a, HF 7b, HF 8) aufweist.

8. Vorrichtung nach Anspruch 7, dadurch gekennzeichnet, daß der Kraftwerksblock zusätzlich Ultraschallaufnehmer (US 1a, US 1b, US 3, US 4, US 5, US 7a, US 7b) als Betreibsmeßgeräßte aufweist, insbesondere im Wasersammelring einer ggf. vorhandenen Kühlung der Ständerwicklung und in den Maschinen- bzw. Eigenbedarfs-Transformatoren (MT a, MT b, EBT a, EBT b).

**Revendications**

1. Procédé pour identifier et localiser des endommagements dans des installations électriques, notamment des génératrices ou des blocs de centrales électriques, selon lequel on exécute, éventuellement respectivement dans toutes les phases, des mesures de décharges partielles ou des mesures à haute fréquence (HF 1a, HF 1b, HF 2a, HF 2b, HF 3, HF 4, HF 5, HF 6, HF 7a, HF 7b, HF 8) en un ou plusieurs point et selon lequel on compare les valeurs de mesure entre elles ou à des signaux de calibrage et on en déduit le point et le type de l'endommagement, caractérisé par les points remarquables suivants:

a) les mesures sont exécutées de façon continue ou périodique en ou moins trois points, pendant le fonctionnement de l'installation;

b) l'installation électrique est simulée dans un ordinateur sous la forme d'un réseau à haute fréquence, des endommagements pouvant être également simulés avec les signaux de l'installation apparissant au niveau des points de mesure;

c) lors l'apparition de valeurs de mesure qui indiquent des endommagements, ces dernières sont comparées aux valeurs simulées de signaux pour des endommagements différents et des points différents d'endommagements, notamment pour ce qui concerne le spectre des fréquences, le temps de propagation, l'amplitude et/ou la position de phase;

d) le type et le point de l'endommagement sont déterminés à partir des valeurs simulées de signaux, qui coïncident le mieux avec les valeurs de mesure, et des endommagements simulés associés.

2. Procédé suivant la revendication 1, caractérisé par le fait que pendant le fonctionnement, on exécute au moins trois des mesures indiquées ci-aprés;

a) découplage des hautes fréquences par l'intermédiaire de diviseurs capacitifs, connus en soi, des traversées de la haute tension des transformateurs (HF 1a, HF 1b);

b) découplage de hautes fréquences (HF 2a, HF 2b) par l'intermédiaire de résistance à haute fréquence en liaison avec des quadripôles de couplage formant diviseurs, en direction des condensateurs (NSK) de protection du réseau, présents;

c) découplage de hautes fréquences au moyen d'un couplage capacitif (HF 3.1) ou inductif (HF 3.2) à l'intérieur de la génératrice (GE), au niveau des différents conducteurs de phase, aux lignes de commutation;

d) découplage des fréquences par des transformateurs d'intensité à haute fréquence au moyen d'une dérivation à partir du neutre (HF 4.1) on d'un diviseur capacitif raccordé au neture, par rapport à la terre (HF 4.2);

e) découplage des hautes fréquences au moyen de transformateurs d'intensité à haute fréquence par l'intermédiaire d'une ligne séparée de raccordement à la terre du paquet de tôles statoriques (HF 5);

f) découplage capacitif des hautes fréquences par l'intermédiaire de l'arbre de la génératrice et de paliers d'excitation (HF 6), éventuellement avec un couplage supplémentaire à l'antenne;

g) découplage des hautes fréquences moyennant l'utilisation en mode capacitif de l'armature de mise à la terre du câble ou de diviseurs ohmiques présentant une caractéristique à haute fréquence dans le plan de tension pour des systèmes auxiliaires (HF 7a, HF 7b);

h) découplage des hautes fréquences au moyen d'une liaison capacitive ou galvanique ou ohmique (HF 8) dans le dispositif (GS) de protection de la génératrice.

3. Procédé suivant la revendication 1 ou 2, caractérisé par le fait que pour la localisation de la phase concernée, on compare entre elles les valeurs de mesure des 3 phases.

4. Procédé suivant la revendication 1 ou 2, caractérisé par le fait qu'on compare entre eux les points de mesure, éventuellement séparément phase par phase.

5. Procédé suivant l'une des revendications précédentes, caractérisé par le fait qu'on analyse l'intensité, la forme et/ou la position de phase des signaux parasites des différents points de mesure au moyen de l'enregistreur de phénomènes transitoires et/ou sur l'écran d'un oscilloscope.

6. Procédé suivant l'une des revendications précédentes, caractérisé par le fait que l'on contrôle en outre simultanément des capteurs de mesure acoustique (US 1a, US 1b, US 3, US 4, US 5, US 7a, US 7b) et qu'on utilise simultanément ces valeurs de mesure lors de l'analyse de l'endommagement.

7. Dispositif pour la mise en oevre du procédé suivant l'une des revendications 1 à 6 dans un bloc de centrale électrique, caractérisé par le fait que le bloc de la centrale électrique comporte, au niveau de sa génératrice (GE) et/ou d'autres modules, trois ou un plus grand nombre de points de mesure de fonctionnement pour le découplage des hautes fréquences (HF 1a, HF 1b, HF 2a, JF 2b; JF 3, HF 3, HF 4, HF 5, HF 6, HF 7a, HF 7b, HF 8).

8. Dispositif suivant la revendication 7, caractérisé par le fait que le bloc de la centrale électrique comporte en outre des capteurs à ultrasons (US 1a, US 1b, US 3, US 4, US 5, US 7a, US 7b) en tant qu'appareils de mesure de service, notamment dans l'anneau collecteur d'eau d'un dispositif éventuellement présent de refroidissement de l'enroulement statorique et dans le transformateurs (MT a, MT b, EBT a, EBT b) de la machine ou de systèmes auxiliaires.

**Claims**

1. Process for the recognition and localization of defects in electrical installations, more particularly generators or power units, whereby at one or several points of the electrical installation partial discharge measurements or high-frequency measurements (HF 1a, HF 1b, HF 2a, HF 2b, HF 3, HF 4, HF 5, HF 6, HF 7a, HF 7b, HF 8), if necessary at all phases respectively, are carried out whereby the measured values are compared with one another or with calibrating signals and the place and type of the defect is inferred therefrom, characterized by the following features:

a) The measurements are carried out during the operation of the installation continuously or periodically at at least three points;

b) the electrical installation is simulated in a computer as a high-frequency network, whereby defects with their signals resulting therefrom at the measuring points can also be simulated;

c) upon the occurrence of measured values which indicate defects, these are compared to the simulated signal values for various defects and places of defect, more particularly with regard to frequency spectrum, running time, amplitude and/or phase relation;

d) the type and the place of the defect are detected from the simulated signal values that best correspond to the measured values, and from the appertaining simulated defects.

2. Process according to claim 1, characterized in that during the operation at least three of the measurements indicated in the following are carried out:

a) High-frequency decoupling by means of capacitive dividers known in themselves of the high-voltage bushings of the transformers (HF 1a, HF 1b);

b) High-frequency decoupling HF 2a, HF 2b by means of high-frequency resistances in connection with four-terminal coupling circuits as sub-dividers to the present network protection capacitors (NSK);

c) High-frequency decoupling through capacitive (HF 3.1) or inductive (HF 3.2) coupling within the generator (GE) phase-wise on the switching lines;

d) High-frequency decoupling through high-frequency current transformers by means of a star point lead (HF 4.1) or capacitive dividers in the star point towards earth (HF 4.2);

e) High-frequency decoupling through high-frequency current transformers by means of a separate earth conductor of the laminated stator code (HF 5);

f) High-frequency decoupling, capacitive, by means of generator shaft and exciter bearing (HF 6), possibly with additional antenna coupling;

g) High-frequency decoupling by means of capacitive use of the cable earth covering or ohmic dividers with a high-frequency characteristic on the auxiliary-service voltage-level (HF 7a, HF 7b);

h) High-frequency decoupling by means of capacitive or direct or ohmic tying (HF 8) in the generator protection (GS).

3. Process according to claim 1 or 2, characterized in that for the location of the phase concerned the measured values of the 3 phases are compared with one another.

4. Process according to claim 1, 2 or 3, characterized in that the measuring points are compared with one another, if necessary separately according to phases.

5. Process according to one of the preceding claims, characterized in that the interference signals of the various measuring points are analysed by means of transient recorders and/or on the oscilloscope screen according to height, shape and/or phase relation.

6. Process according to one of the preceding claims, characterized in that in addition measured values are also monitored by sound measuring detectors (US 1a, US 1b, US 3, US 4, US 5, US 7a, US 7b) and are also drawn upon in the analysis of the defect.

7. Device for carrying out the process according to one of claims 1 to 6 on a power unit, characterized in that the power unit on its generator (GE) and/or further structural parts has three or more operational measuring points for high-frequency decoupling (HF 1a, HF 1b, HF 2a, HF 2b, HF 3, HF 4, HF 5, HF 6, HF 7a, HF 7b, HF 8).

8. Device according to claim 7, characterized in that the power unit in addition has ultrasound detectors (US 1a, US 1b, US 3, US 4, US 5, US 7a, US 7b) as operational measuring apparatus, more particularly in the water collecting ring of a cooling device, present if necessary, of the stator winding and in the machine transformers or auxiliary-service transformers (MT a, MT b, EBT a, EBT b).

FIG 1

FIG 2

Meßstelle 1...m

| Störsignal Erfassung (HF) |

| Systemimpuls- erkennung |

System- Impuls ? — ja

nein

| Speichern | → | Vergleich HF - US | ← | Speichern |

Meßstelle 1...n

| Schallpegel- Messung (US) |

| Impuls- erkennung |

Speichern Impuls ? — ja

nein

R.S.T → | Meßstellen- und Strang- vergleich |

/ Meldung /

/ Anlagen- Komponente /

| Impuls- Analyse |

| US-Ortung |

/ Anlagen Kompo- nente / → | Vergleich Grobortung | ← | Modell- Netzwerk |

| Block A |

| Vergleich Feinortung | ← | Anlagen Komponenten |

| Vergleich HF - US |

/ Fehlerort Fehlerart /

Überein- stimmend ? — nein → / Ausgabe US-Feh- ler /

ja

/ Fehler i. Komponente /

## FIG 3

FIG 4

EP 0 241 764 B1